# EUROPEAN PATENT SPECIFICATION

(11) **EP 1 538 678 B1**
(45) Date of publication and mention of the grant of the patent: **16.07.2008**
(21) Application number: 04106161.5
(22) Date of filing: 29.11.2004
(51) Int. Cl.: H01L 29/78, H01L 29/08, H01L 29/417, H01L 29/45, H01L 21/336

(54) **DMOS structure and method of making the same**
DMOS-Struktur und Verfahren zu deren Herstellung
Structure DMOS et sa méthode de fabrication

(30) Priority: 05.12.2003 EP 03425782
(43) Date of publication of application: 08.06.2005
(73) Proprietor: STMicroelectronics S.r.l., 20041 Agrate Brianza (Milano) (IT)
(72) Inventor: Brambilla, Danele Alfredo, 20050, Sovico (IT)
(74) Representative: Pellegri, Alberto

(56) References cited:
- EP-A- 1 158 583
- US-A- 5 719 421
- US-A- 5 825 065
- PATENT ABSTRACTS OF JAPAN vol. 005, no. 159 (E-077), 14 October 1981 (1981-10-14) & JP 56 088363 A (NEC CORP), 17 July 1981 (1981-07-17)

## Description

### FIELD OF THE INVENTION

The present invention relates to integrated circuits, and in particular to a method of fabricating a DMOS structure, said DMOS structure being of enhanced characteristics in withstanding high currents while retaining a low on-resistance and which can be integrated with enhanced compactness.

### BACKGROUND OF THE INVENTION

A DMOS structure is constituted by a drain region, a source region and a gate defined over a channel region. In the case of an N-channel device, the source-body region that is realized in correspondence of a purposely defined opening of a polysilicon gate layer, includes a P-body diffusion formed inside an N- pocket, a single or, more commonly, a shallow N- and a deeper N+ source diffusions are formed in succession in the P-body region, by successive implants, self-aligned to the definition edges of the poly (gate) opening and to dielectric spacers successively formed there along, respectively, according to well known VLSI and ULSI fabrication techniques. A source contact is established on the N+ source diffusion (of course the types of conductivities are inverted in the case of a P-channel device).

The document US-A-5,719,421 discloses an integrated DMOS transistor structure with reduced area occupancy resulting form the formation of a non-annular source region and the formation of a backgate contact region in the source region so as to counterdope and extend through portion of the source region in order to contact a backgate region.

Problems arising from the fact that in operation and specially at relatively high currents, the potential of the N+ source diffusion tends to differ from the potential of the P-body diffusion containing it, are solved by locally short-circuiting the N+ source diffusion to the P-body by realizing an electrical connection by way of a dedicated electrical connection P+ diffusion that extends in depth through the N+ source diffusion reaching down to the P-body region. This P+ diffusion of electrical connection is short-circuited to the N+ diffusion by a source contact formed thereon.

Of course, the same considerations hold also for a P-channel device that is realized by inverting the types of conductivity (dopants) of the various regions.

With the advent of ULSI technologies, the size of the contacts have been reduced to allow for a greater density of integration and as a result the N+ and P+ diffusions could hardly be short-circuited in a manner to ensure substantial equipotentiality by way of a single contact of such minimized cross section. Therefore, ULSI DMOS structures (N-channel or P-channel) generally have source regions provided with a plurality of minimum size contacts formed on the (N+ or P+) source diffusions and larger size contacts on the local plug diffusions (p+ or N+) of electrical connection to the body region. The local short-circuit between the P+ and N+ diffusions is thence established through the common source contact metallization.

The document EP-A-1 158 583 discloses a ULSI LDMOS structure employing a layer of silicide or the source region for short circuiting the source diffusion and an electrical connection diffusion, wherein source contact are established onto said silicide layer.

Furthermore, US-A-5 825 065 discloses a DMOS structure, wherein the source region has a lightly doped portion, a silicide layer short circuiting a heavily doped position of the source region and a backgate region.

Even the residual drawback of this solution of causing current density disuniformities in the source region because of charge carriers (electrons and holes) being collected through distinct contacts, thus reducing the robustness of the device when operating at high currents because of a premature turning on of the intrinsic parasite bipolar junctions transistor (NPN or PNP), was overcome by the invention disclosed in prior patent application EP-A-1 158 583-A1, of the same Applicants.

According to this prior application, an electrically conductive layer of silicide formed in a self-aligned manner (from where the acronym SAlicide) over the whole silicon surface in the source region area, effectively short-circuits the source (N+ or P+) diffusion and the plug diffusion (P+ or N+) of electrical connection of the underlying body region, while the electric current eventually flows through one or more contacts formed on the silicide layer. According to a preferred embodiment of that technique, at least a source contact is projectively formed over the area of the plug diffusion (P+ or N+) of electrical connection.

In any case, the layout of the contacts in the source region influences the on-resistance of integrated DMOS devices.

For a typical layout of a DMOS device, the on-resistance per unit area of integration is proportional to the "pitch" distance between the source contacts and the drain contacts, and inversely proportional to the width W of the drain and source regions. For a given width W of the drain and of the source regions, the on-resistance per unit area of integration may be lowered only by reducing as much as possible the distance between such regions within the limits imposed by the fabrication technology.

The layout of a DMOS structure is practically symmetrical for p-channel and n-channel devices.

Basically the layout is defined by four masks:
- the body mask which defines the opening through the polysilicon gate layer in correspondence in the source/body region of the structure;
- the contact (opening) and source (island) masks that are commonly designed at minimum lithographical dimension;
- the body contact mask, by which a sufficient effective distance from the polysilicon (gate electrode) edge to the "plug" of heavily doped silicon of type of conductivity opposite to that of the surrounding source region, reaching down in depth to contact the underlying body region, is defined to ensure adequate voltage withstanding characteristics.

Although the use of SAlicide layer, onto which forming at least a source-body contact and if required a plurality of source contacts formed spacingly along the central axis in the width direction W of the opening through the polysilicon, has significantly helped in enhancing the resulting conductivity of an integrated DMOS structure by accomplishing a most even distribution of the lines of current in the silicon toward the multiple source contacts and in reducing the width and pitch of the structure for comparable electrical performances, has imposed the requisite of providing for the presence of a continuous heavily doped superficial region within the source region definition opening through the polysilicon, in order to achieve an optimization of conduction characteristics. In fact, formation of a highly conductive layer of SAlicide thereon is favored by the presence of heavily doped silicon at the surface.

Such a requisite is generally fulfilled by the continuity of the relatively heavily doped source area implant (N+) surrounding the area of definition of the body contact plug diffusion (that needs to be masked from the heavy source implant by a resist cap or island) in order to ensure continuity of a heavily doped silicon surface area along the W direction of the opening through the polysilicon layer.

Of course, the two sides of the body contact plug diffusion heavily implanted with a dopant (P+) of opposite type of conductivity to that of the (N+) source dopant, must remain at a sufficient distance from the definition edge of the polysilicon (gate electrode) to preserve voltage withstanding characteristics of the integrated structure.

Therefore, on account of the tolerances of alignment of three distinct masks that are normally used, namely: the heavy source N+ implant mask, for operatively defining the area of the body contact plug diffusion, the contact opening mask and the mask for implanting the dopant of the body contact plug diffusion and of the overlay that need to be considered, the width of the opening in the polysilicon must be necessarily made sufficiently large for ensuring a sufficient distance of separation between the side of the central mask window used for implanting the body contact plug diffusion dopant and the definition edge of the poly (gate), which inevitably limits the possibility of reducing the width in the pitch direction of the elongated openings through the polysilicon gate layer.

These technological contraints relative to the definition of features within the poly openings of source regions, limit the possibility of further reducing the pitch of integration and therefore of the overall level of compactness that can be achieved with a certain fabrication technology. Also the ability to reduce the on-resistance for unit area of integration of the structure is similarly limited.

### SUMMARY OF THE INVENTION

To the above-noted limitations of the known integrated DMOS structures and relative process of fabrication, the present applicants have found an effective solution.

A method of fabricating a DMOS structure in accordance with the present invention is set out in claim 1. A specific embodiment is disclosed in claim 2.

It has been found that the pitch of integration of an DMOS structure may be further significantly reduced and/or the on-resistance per unit area of integration of the structure significantly increased while preserving adequate voltage withstanding characteristics of the integrated structure, by the ability provided by this invention of reducing the width (in the pitch direction) of the opening through the polysilicon gate layer in correspondence of each body-source island far beyond the limits imposed in the structures made according to the prior art, for the reasons mentioned above.

The invention rests on a finding that continuity of the heavily doped superficial silicon region along the axis of the elongated source island openings through the polysilicon gate layer in the width direction (W) of the integrated structure, no longer needs to be assured by defining it with a width (in the pitch direction) sufficiently large to account for the overlay of two distinct and relatively critical masks, namely: the source implant mask and the body contacting plug diffusion implant contact opening mask, which was responsible of limiting the possibility of restricting the opening through the polysilicon gate layer in order to safely ensure an appropriate distance of the body connection plug diffusion dopant profile from the definition edges of the polysilicon.

Contrary to the manufacturing methods of the prior art, the body connection plug diffusion implant area is, according to this invention, defined by way of a mutual orthogonality between two no longer critical masks that may both be defined at minimum linewidth of the fabrication process.

Accordingly, the source implant mask defines within the opening through the polysilicon gate layer a certain area in the form of a strip orthogonal to the width direction (W) and extending across the opening through the polysilicon gate layer that is masked from the source implant and that therefore receives only a first shallow light doping source implant before formation of the dielectric spacers on the definition edges of the opening through the polysilicon gate layer. For the fullest compactness enhancement afforded by this invention, such an orthogonal masked strip may be defined at minimum linewidth of the fabrication process, however, the width of such a source implant mask extending across the opening through the polysilicon gate layer, that is orthogonally in respect of the width direction (W) of the integrated structure, may even be larger than the minimum linewidth with which will be successively defined the source contact metal.

Similarly, the mask of body connection plug diffusion area implant defining an implant window in the form of a continuous strip along the central axis in the width direction (W) of the opening through the polysilicon gate layer may be defined at minimum linewidth.

In any case, differently from the existing techniques, the linewidth of definition of the two masks of heavy source implant area and of the body connection plug diffusion implant area (the latter being defined in the crossover area of the orthogonal implant windows of the two masks) may both be the same as the width of definition of the source contact to be formed on the layer of silicide in correspondence of the body contact plug diffusion. Most advantageously, the linewidth may be the minimum afforded by the fabrication process.

Of course, the implanted dopant of the body connection plug diffusion is received along such a central strip of minimum linewidth also by the heavily doped silicon of the source region without inverting the type of conductivity thereof.

By defining the implant window of the body connection plug diffusion dopant as an orthogonal strip of minimum linewidth, instead of a centered island area, the need of accounting for an adequate overlay is eliminated and overall renders the two masks that define (at their crossover) the implant area of the plug diffusion no longer critical.

Surprisingly, it has been found that any "necking" of the most conductive portion of the area of the successively deposited silicide layer, that may be consequent of a reduced concentration of dopant present at the surface of the silicon from the diffusion profile line of the body contact play diffusion dopant to the edge of definition of the gate polysilicon in correspondence of the orthogonal strip of definition of minimum linewidth of the source implant mask does not affect in any sensible manner the electrical conduction behavior (equipotentiality) of the source contacts and of the body-source short-circuiting provided by the silicide layer.

### BRIEF DESCRIPTION OF THE DRAWINGS

The various aspects and advantages of this invention will become even clearer through a detailed description of an important embodiment of this invention in fabricating a lateral DMOS transistor structure (LDMOS), though the invention may obviously be practiced and is beneficial also for fabricating a so-called vertical DMOS transistor structure (VDMOS) according to modem VLSI and ULSI fabrication technologies, and by referring to the attached drawings, wherein:
**Figure 1** is a layout view showing the features of an LDMOS structure of this invention;
**Figure 2** is a partial cross sectional view in the plane A-A of Figure 1;
**Figure 3** is a partial cross sectional view in the plane B-B of Figure 1;
**Figure 4** is a pictorial representation of the effects of the absence of the heavy source implant along the orthogonal minimum linewidth masked area across the opening through the polysilicon.

### DESCRIPTION OF A PREFERRED EMBODIMENT OF THE INVENTION

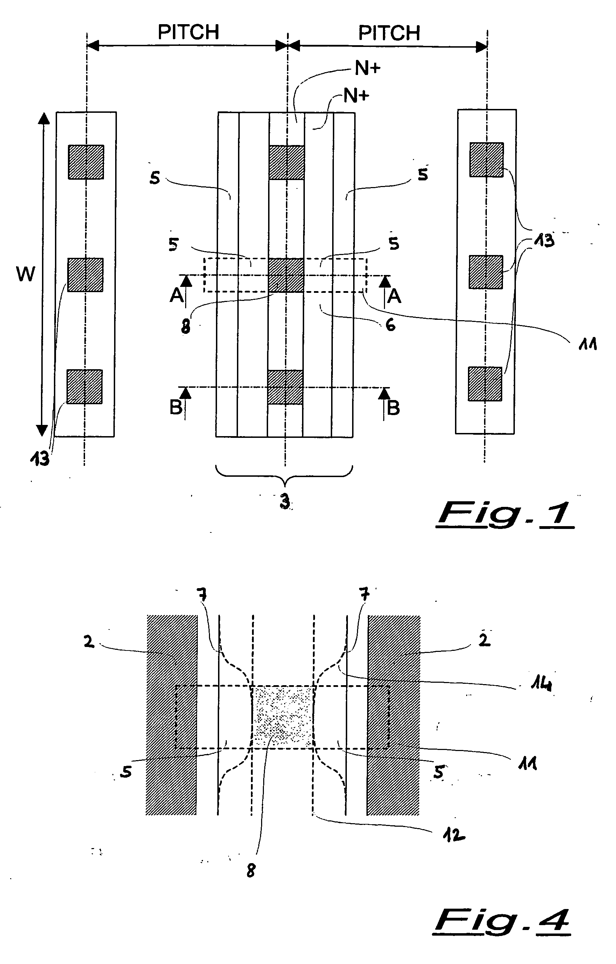

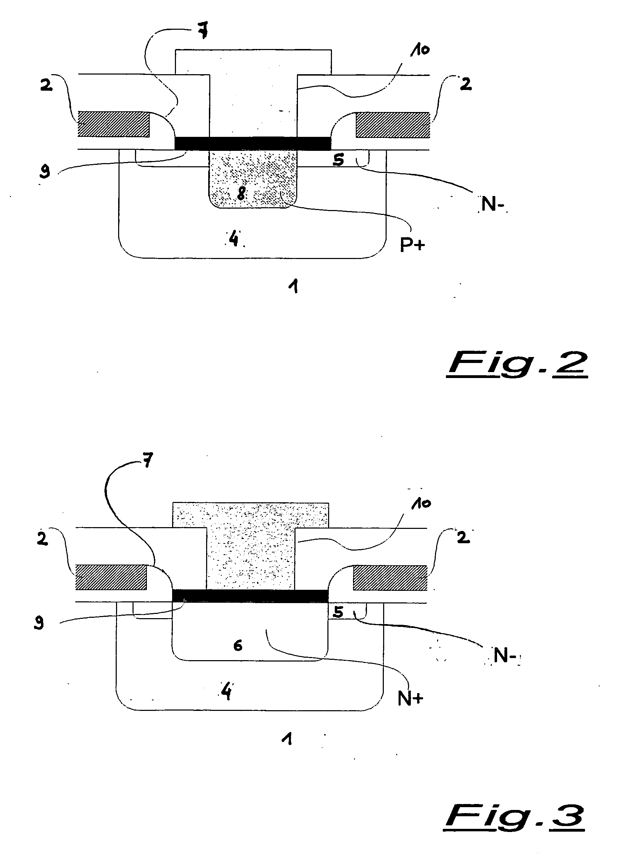

The basic layout view of an integrated LDMOS N-channel structure disposed in an N-pocket (1) of a semiconductor substrate, having drain contacts (13), a source contact (10), a body diffusion (4), source diffusions (5, 6), a body connection plug diffusion (8) and dielectric spacers (7), and being made according to the present invention, is shown in Figure 1, while Figures 2 and 3 are partial cross sectional views along the section planes A-A and B-B, respectively.

As may be clearly observed in the layout view of Figure 1, the N+ mask (11) used for implanting the source region in self-alignment with the spacers (7) formed on the edges of definition of the opening (3) through the polysilicon gate layer (2), masks from the N+ implant an orthogonal strip across the full width of the poly opening (3), practically leaving in the masked area only the LDD N- source diffusion (5) This represents a discontinuity of the N+ source diffusion (6) in the source region defined by the opening through the polysilicon gate layer (2), alongwith the W direction of the integrated LDMOS structure.

According to a preferred embodiment, the N+ mask (11) may be defined with the minimum linewidth of the process of fabrication, like the source contacts (10).

Another feature of the structure of this invention, is represented by the fact that the P+ mask (12) that is used for implanting the P+ dopant in the crossover area with the N+ mask (11), for realizing the body connection plug diffusion P+ (8) and which eventually also increases the total dopant species concentration in the silicon region extending along the central axis of the source region in the width direction W of the integrated structure though without inverting the type of conductivity conferred to it by the higher N+ source implant, is also defined with the minimum linewidth, centered about the central axis of the source region in the W direction.

In this way, the body connection plug diffusion P+(8) is defined by way of the orthogonality of the two masks (11, 12) N+ and P+ (crossover area), without accounting for any overlay that by contrast was necessary to account for in the known process.

According to such a preferred embodiment, the width of the longitudinal central strip of the N+ source diffusion (6) that eventually receives also the P+ dopant in an amount short of compensation of the N+ heavy source doping, has minimum linewidth, like the N+ mask (11) and the source contact mask.

The no longer critical character of the masks and consequent elimination of overlays permits a significative reduction of the transversal width of the openings (3) through the polysilicon gate layer (2) an consequently a reduction of the pitch of integration.

For a sample implementation with a linewidth of definition of the source contact areas and of the implant window of the body connection plug diffusion dopant of 0.4 µm, according to the prior art method, the width of the longitudinal central strip of the source region, receiving the heavy implants of dopants of opposite type of conductivities, because of the necessary overlays of about 0.1 µm on each side, would become 0.6 µm and by considering the spacers, the total width of the poly opening will be of about 1.2 µm.

By contrast, according to the novel method of this invention, for the same linewidth of definition of the source contact areas and of the implant window of the body connection plug diffusion dopant, the fact that the overlays mentioned above are no longer required, permits to narrow the width of the poly openings of source areas to about 0.8 µm, practically to 2/3 of the width that was necessary in the prior process.

In general, according to present fabrication technologies of power DMOS devices, the minimum linewidth of definition used ranges from 0.3 to 0.8 µm, and according to the known definition approach, the overlays in defining the width of the longitudinal central strip area of a source island, range from 0.1 to 0.3 µm and the lateral extension of dielectric spacers may range from 0.2 to 0.9 µm. In any case, the novel approach of the present applicants to realize the required shotcircuiting of the body region to the source contacts permits to achieve a significative reduction of the width of the poly openings of the source islands and therefore a consistent shrinkage of the whole DMOS structure.

It has been found that the effect of the presence of only a lightly doped (LDD) source diffusion (5) in correspondence of the orthogonal strip of minimum linewidth of the N+ mask (11) destined to the definition and formation of the P-body connection plug diffusion P+(8), does not affect in any detectable manner the electrical conducting behavior of the source contact (10) and local body-source shortcircuiting afforded by the presence of a conductive layer of silicide (9).

In practice, although theoretically an effect of the type that has been pictorially illustrated in Figure 4 and which may be summarized in admitting a "necking" effect in coincidence of the LDD zones (5) of minimum linewidth bridging the space of separation between the body connection plug diffusion definition area and the definition edge of the polysilicon gate layer (2), of a highly conductive silicide layer portion (14), on the silicon surface in the source region may be present it does not jeopardize an effective electrical continuity with the body connection plug diffusion (8) and has an overall negligible detrimental effect in maintaining a substantial equipontentiality of the source contact (10) and body-source short-circuiting silicide layer (9).

In other words, the highly conductive silicide layer (9) remains electrically continuous along the width direction W of the source region of the integrated LDMOS structure, notwithstanding the local discontinuity deliberately caused in the N+ source diffusion (6) and the consequent presence of local lightly doped zones (5) at the surface of the silicon, between the heavily doped central area of the P+ plug diffusion (8) and the opposing edge of the gate electrode layer (2).

Of course, all the considerations that have been made with reference to the drawings referring to the realization of an N-channel device, hold also for the case of a P-channel device, by simply inverting the type of polarity of the dopants. Differences between N-channel and P-channel devices reversibly depend on whether, for the fabrication process being used, the N+ junction is higher (as in the illustrated example) or lower in doping compared to the P+ junction, as will be obvious to a person skilled in the art.

The effectiveness of the DMOS structure fabricated in accordance with this invention has been demonstrated for a number of different devices and the respective area savings that were obtained, for a minimum linewidth embodiment, are reported in the following table, in which are also compared the pitch of integration of structures made according to the prior art with the pitch of integration of the improved DMOS structure (SMART) made according to the present invention.

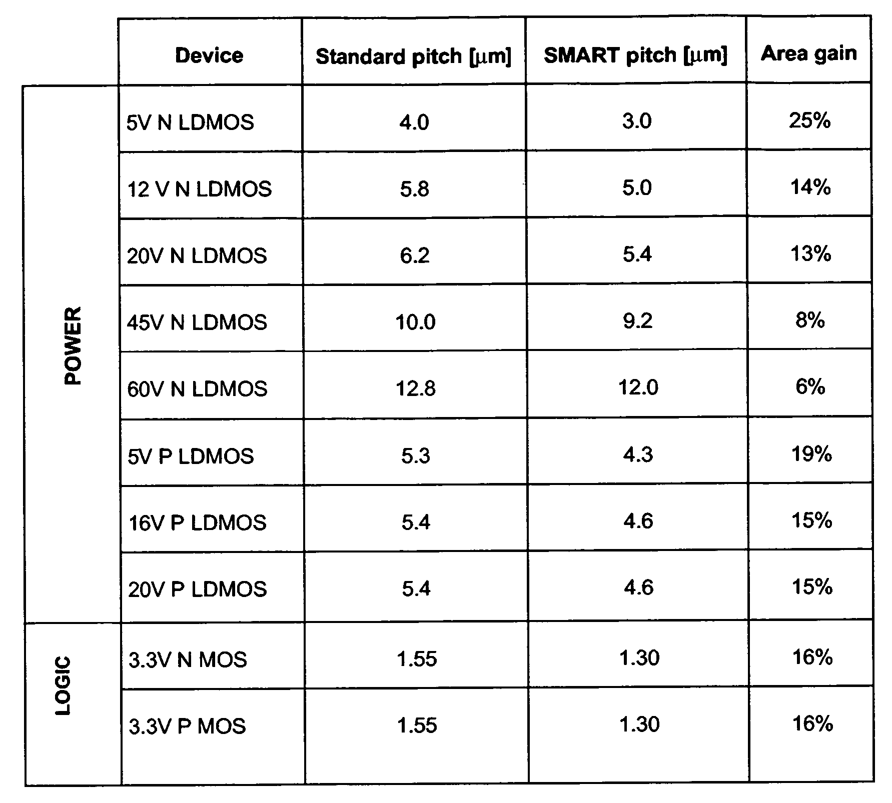

Preliminary bench measurements on first prototype lot of wafers (Smart pitch) confirmed a lower on-resistance per unit area of integration, an equal or higher transconductance and an equal or higher breakdown voltage, compared to the devices made according to the prior art (Standard pitch).

## Claims

1. A method of fabricating a DMOS structure in a region of a first type of conductivity (1) of a semiconductor substrate and comprising forming a polysilicon gate layer (2), drain regions and source regions spacingly and parallelly extending in a first direction for a certain width (W) of the DMOS structure, each source region being formed in correspondence of an opening (3) through said polysilicon gate layer, elongated in said first direction forming each source region comprising implanting a body diffusion (4) of a second type of conductivity in self-alignment to the edges of said opening, implanting a first source diffusion (5) of said first type of conductivity in self-alignment to the edges of said opening, implanting a second source diffusion (6) in self-alignment to the edges of dielectric spacers (7) formed on the edges of said opening except for a central area in a second direction orthogonal to said first direction masked from the second source implant, and implanting a body connection plug diffusion (8) of said second type of conductivity in said central area, reaching down to said body diffusion, forming a layer of silicide (9) over the semiconductor surface of said second source diffusion and of said body connection plug diffusion and forming at least a source least a source contact (10) over said silicide layer in correspondence of said body connection plug diffusion, the method further comprising defining the implant area of said body connection plug diffusion in the crossover area of the implant mask (11) of said second source diffusion defining a strip extending in said second direction across said opening in the polysilicon gate layer and of an implant mask (12) of said body connection plug diffusion defining a strip of the same linewidth as said strip of the implant mask of said second source diffusion and along a central axis of the opening in said first direction.

2. The method of claim 1, wherein said same linewidth is the minimum linewidth afforded by the fabrication process.

## Patentansprüche

1. Verfahren zum Herstellen einer DMOS-Struktur in einer Zone eines ersten Leitfähigkeitstyps (1) eines Halbleitersubstrats, das aufweist: Bilden einer Polysilizium-Gate-Schicht (2), von Drain-Zonen und Source-Zonen, die sich über eine bestimmte Breite (W) der DMOS-Struktur mit einem Abstand und parallel in eine erste Richtung erstrecken, wobei jede Source-Zone entsprechend zu einer Öffnung (3) durch die Polysilizium-Gate-Schicht gebildet wird, die in die erste Richtung verlängert ist, Bilden jeder Source-Zone, aufweisend: Implantieren einer Körperdiffusion (4) eines zweiten Leitfähigkeitstyps in Selbstausrichtung mit den Rändern der Öffnung, Implantieren einer ersten Source-Diffusion (5) des ersten Leitfähigkeitstyps in Selbstausrichtung mit den Rändern der Öffnung, Implantieren einer zweiten Source-Diffusion (6) in Selbstausrichtung mit den Rändern dielektrischer Abstandsstücke (7), die an den Rändern der Öffnung ausgebildet sind, mit Ausnahme eines zentralen Bereichs in eine zweite Richtung orthogonal zur ersten Richtung, die vom zweiten Source-Implantat maskiert ist, und Implantieren einer Körperverbindungsstöpseldiffusion (8) (body connection plug diffusion) des zweiten Leitfähigkeitstyps im zentralen Bereich, hinabreichend bis zur Körperdiffusion, Bilden einer Silizidschicht (9) über der Halbleiteroberfläche der zweiten Source-Diffusion und der Körperverbindungsstöpseldiffusion (body connection plug diffusion) und Bilden mindestens eines Source-Kontakts (10) über der Silizidschicht, die der Körperverbindungsstöpseldiffusion (body connection plug diffusion) entspricht, wobei das Verfahren ferner aufweist: Definieren des Implantatbereichs der Körperverbindungsstöpseldiffusion (body connection plug diffusion) im Kreuzungsbereich der Implantatmaske (11) der zweiten Source-Diffusion, Definieren eines Streifens, der sich in die zweite Richtung über die Öffnung in der Polysilizium-Gate-Schicht erstreckt, und einer Implantatmaske (12) der Körperverbindungsstöpseldiffusion (body connection plug diffusion), Definieren eines Streifens mit derselben Linienbreite wie der Streifen der Implantatmaske der zweiten Source-Diffusion und längs einer Mittelachse der Öffnung in die erste Richtung.

2. Verfahren nach Anspruch 1, wobei dieselbe Linienbreite die minimale Linienbreite ist, die durch den Herstellungsprozeß ermöglicht wird.

## Revendications

1. Procédé de fabrication d'une structure DMOS dans une région d'un premier type de conductivité (1) d'un substrat semiconducteur, comprenant les étapes suivantes :
former une couche de grille en polysilicium (2), des régions de drain et des régions de source s'étendant avec un pas et parallèlement dans une première direction sur une certaine largeur (W) de la structure DMOS, chaque région de source étant formée en correspondance avec une ouverture (3) dans la couche de grille en polysilicium, allongée dans la première direction ;
former chaque région de source
en implantant une diffusion de corps (4) d'un deuxième type de conductivité en auto-alignement avec les bords de l'ouverture,
en implantant une première diffusion de source (5) du premier type de conductivité en auto-alignement avec les bords de l'ouverture,
en implantant une deuxième diffusion de source (6) en auto-alignement avec les bords d'espaceurs diélectriques (7) formés sur les bords de l'ouverture à l'exception d'une zone centrale dans une deuxième direction orthogonale à la première direction masquée par la deuxième implantation de source, et
en implantant une diffusion de prise de connexion de corps (8) du deuxième type de conductivité dans la zone centrale, atteignant par le bas la diffusion de corps ;
former une couche de siliciure (9) sur la surface conductrice de la deuxième diffusion de source et de la diffusion de prise de connexion de corps, et former au moins un contact de source (10) sur la couche de siliciure en correspondance avec la diffusion de prise de connexion de corps ;
le procédé comprenant en outre la définition de la zone d'implantation de la diffusion de prise de connexion de corps dans la zone de croisement du masque d'implantation (11) de la deuxième diffusion de source définissant une bande s'étendant dans la deuxième direction à travers l'ouverture dans la couche de grille en polysilicium et d'un masque d'implantation (12) de la diffusion de prise de connexion de corps définissant une bande de la même largeur de ligne que la bande du masque d'implantation de la deuxième diffusion de source et suivant un axe central de l'ouverture dans la première direction.

2. Procédé selon la revendication 1, dans lequel la même largeur de ligne est la largeur de ligne minimum permise par le processus de fabrication.
